# EUROPÄISCHE PATENTANMELDUNG

(11) **EP 1 901 357 A2**
(43) Veröffentlichungstag der Anmeldung: **19.03.2008**
(21) Anmeldenummer: 07016950.3
(22) Anmeldetag: 29.08.2007
(51) Int. Cl.: H01L 33/00

(54) **Optoelektronischer Halbleiterchip**

(30) Priorität: 15.09.2006 DE 102006043400
(71) Anmelder: Osram Opto Semiconductors GmbH & Co. OHG, 93049 Regensburg (DE)
(72) Erfinder: Albrecht, Tony, 93077 Bad Abbach (DE); Brüderl, Georg, 93133 Burglengenfeld (DE); Härle, Volker, 93164 Laaber (DE); Höppel, Lutz, 93087 Alteglofsheim (DE); Straßburg, Martin, 93105 Tegernheim (DE)
(74) Vertreter: Epping - Hermann - Fischer

(57) **Zusammenfassung**

Es wird ein optoelektronischer Halbleiterchip mit
- einem Aufwachssubstrat (1) mit einer strukturierten Aufwachsfläche (2), die eine Vielzahl von Erhebungen (4) und Senken (3) aufweist, und
- einer aktiven Schichtenfolge (5), die auf die Aufwachsfläche (2) aufgebracht ist, angegeben.

## Beschreibung

Es wird ein optoelektronischer Halbleiterchip angegeben.

Die Druckschrift US 2003/0085409A1 beschreibt einen optoelektronischen Halbleiterchip.

Eine zu lösende Aufgabe besteht darin, einen optoelektronischen Halbleiterchip anzugeben, der besonders effizient betrieben werden kann. Eine weitere zu lösende Aufgabe besteht darin, einen optoelektronischen Halbleiterchip anzugeben, der besonders kostengünstig herstellbar ist.

Gemäß zumindest einer Ausführungsform des optoelektronischen Halbleiterchips umfasst der Halbleiterchip ein Aufwachssubstrat. Bei dem Aufwachssubstrat handelt es sich beispielsweise um einen Körper, der ein Halbleitermaterial enthält oder aus einem Halbleitermaterial besteht. Das Aufwachssubstrat weist zumindest eine Aufwachsfläche auf. Die Aufwachsfläche ist vorgesehen, auf ihr ein Halbleitermaterial und/oder ein metallisches Material epitaktisch abzuscheiden. Die Aufwachsfläche ist beispielsweise durch eine Hauptfläche des Aufwachssubstrats gebildet.

Gemäß zumindest einer Ausführungsform des optoelektronischen Halbleiterchips ist die Aufwachsfläche des Aufwachssubstrats strukturiert. Das bedeutet beispielsweise, die Aufwachsfläche ist nicht eben oder glatt ausgebildet, sondern vielmehr weist die Aufwachsfläche dreidimensionale Strukturen auf. Bevorzugt weist die Aufwachsfläche eine Vielzahl von Erhebungen und/oder Senken auf. Aufgrund der Strukturierung verfügt die Aufwachsfläche über eine raue Oberfläche, deren Flächeninhalt gegenüber dem Flächeninhalt einer glatten Oberfläche vergrößert ist.

Gemäß zumindest einer Ausführungsform des optoelektronischen Halbleiterchips ist auf die strukturierte Aufwachsfläche des Substrats eine aktive Schichtenfolge aufgebracht. Die aktive Schichtenfolge umfasst beispielsweise eine Mehrzahl von Schichten, wobei zumindest eine Schicht im Betrieb des optoelektronischen Halbleiterchips zur Strahlungsdetektion oder Strahlungserzeugung vorgesehen ist. Beispielsweise umfasst die aktive Schichtenfolge einen pn-Übergang, eine Doppelheterostruktur oder eine Quantentopfstruktur.

Die aktive Schichtenfolge ist vorzugsweise epitaktisch auf die Aufwachsfläche des Aufwachssubstrats abgeschieden. Die aktive Schichtenfolge kann sich dabei zumindest stellenweise formschlüssig an die strukturierte Aufwachsfläche - das heißt beispielsweise, die Erhebungen und/oder Senken - anschließen. Das Profil der strukturierten Aufwachsfläche bildet sich vorzugsweise zumindest stellenweise konform - das heißt, winkeltreu - in der aktiven Schichtenfolge ab. Das bedeutet insbesondere, dass die aktive Schichtenfolge die Strukturierung der Aufwachsfläche nicht einfach überwächst derart, dass eine glatte und/oder ebene äußerste, dem Aufwachssubstrat abgewandte Schicht der aktiven Schichtenfolge entsteht. Vielmehr folgt die aktive Schichtenfolge in ihrer Morphologie der Struktur der Aufwachsfläche zumindest stellenweise nach.

Gemäß zumindest einer Ausführungsform des optoelektronischen Halbleiterchips weist der Halbleiterchip ein Aufwachssubstrat mit einer strukturierten Aufwachsfläche, die eine Vielzahl von Erhebungen und/oder Senken aufweist, auf. Ferner weist der optoelektronische Halbleiterchip eine aktive Schichtenfolge auf, die auf die Aufwachsfläche aufgebracht ist.

Einem hier beschriebenen optoelektronischen Halbleiterchip liegt dabei unter anderem die folgende Idee zugrunde: Auf herkömmliche Weise hergestellte optoelektronische Halbleiterchips umfassen oftmals eine aktive Schichtenfolge, die auf eine glatte, ebene Aufwachsfläche eines Aufwachssubstrats aufgebracht ist. Die aktive Fläche der aktiven Schichtenfolge des Halbleiterchips - das heißt, beispielsweise die zur Strahlungserzeugung oder Strahlungsdetektion vorgesehene Fläche der aktiven Schichtenfolge - ist dann maximal so groß wie die Aufwachsfläche. Aufgrund der hier beschriebenen Strukturierung der Aufwachsfläche ist die Aufwachsfläche vergrößert. Da die aktive Schichtenfolge auf diese strukturierte, vergrößerte Aufwachsfläche aufgebracht ist, ist auch der Flächeninhalt der aktiven Schichtenfolge gegenüber dem Flächeninhalt einer glatten, ebenen aktiven Schichtenfolge vergrößert. Die aktive Schichtenfolge weist also einen größeren Flächeninhalt als die laterale Querschnittsfläche des Aufwachssubstrats auf. Unter der lateralen Querschnittsfläche des Aufwachssubstrats ist dabei der Flächeninhalt der Aufwachsfläche des Aufwachssubstrats vor der Strukturierung, also der Flächeninhalt einer glatten, ebenen Aufwachsfläche verstanden.

Durch die Vergrößerung des Flächeninhalts der aktiven Schichtenfolge kann bei gleich bleibender Chipgröße mehr elektromagnetische Strahlung von der aktiven Schichtenfolge erzeugt oder detektiert werden. Handelt es sich bei dem optoelektronischen Halbleiterchip zum Beispiel um einen Leuchtdiodenchip, so führt die hier beschriebene Vergrößerung des Flächeninhalts der aktiven Schichtenfolge zu einer erhöhten Leuchtdichte bei gleich bleibender lateraler Querschnittsfläche und damit insgesamt zu einem effizienteren Leuchtdiodenchip.

Vorzugsweise weist der Halbleiterchip auch eine dem Aufwachssubstrat abgewandte raue Oberfläche auf, wobei diese raue Oberfläche aus der strukturierten Aufwachsfläche des Aufwachssubstrats resultiert. Handelt es sich bei dem optoelektronischen Halbleiterchip zum Beispiel um einen Leuchtdiodenchip, so bildet diese raue Oberfläche vorzugsweise eine Strahlungsaustrittsfläche des Halbleiterchips. Aufgrund der Rauhigkeit der Strahlungsaustrittsfläche ist die Wahrscheinlichkeit für Totalreflexion beim Strahlungsaustritt reduziert, die Effizienz des Halbleiterchips ist auch dadurch verbessert.

Gemäß zumindest einer Ausführungsform des optoelektronischen Halbleiterchips erzeugt oder detektiert der Halbleiterchip mit der strukturierten Aufwachsfläche im Betrieb mehr elektromagnetische Strahlung, als ein entsprechender Halbleiterchips mit glatter Aufwachsfläche. Unter einem entsprechenden Halbleiterchip ist dabei ein Halbleiterchip verstanden, der abgesehen von der glatten Aufwachsfläche wie der Halbleiterchip mit der strukturierten Aufwachsfläche aufgebaut ist. Insbesondere weist der entsprechende Halbleiterchip auch die gleiche laterale Querschnittsfläche wie der Halbleiterchip mit der strukturierten Aufwachsfläche auf.

Gemäß zumindest einer Ausführungsform des optoelektronischen Halbleiterchips erzeugt oder detektiert der Halbleiterchip mit der strukturierten Aufwachsfläche im Betrieb elektromagnetische Strahlung einer höheren Strahlungsdichte, als ein entsprechender Halbleiterchip mit glatter Aufwachsfläche, der die gleiche laterale Querschnittsfläche wie der Halbleiterchip mit der strukturierten Aufwachsfläche aufweist. Unter einem entsprechenden Halbleiterchip ist dabei ein Halbleiterchip verstanden, der abgesehen von der glatten Aufwachsfläche wie der Halbleiterchip mit der strukturierten Aufwachsfläche aufgebaut ist.

Gemäß zumindest einer Ausführungsform des optoelektronischen Halbleiterchips wird im Betrieb des optoelektronischen Halbleiterchips über die gesamte Fläche der aktiven Schichtenfolge elektromagnetische Strahlung erzeugt oder detektiert. Das heißt, die Erzeugung oder Detektion von elektromagnetischer Strahlung ist nicht auf bestimmte Bereiche der aktiven Schichtenfolge, wie beispielsweise Bereiche der aktiven Schichtenfolge, die in Senken der strukturierten Aufwachsfläche angeordnet sind, beschränkt. Vielmehr sind sämtliche Bereiche der aktiven Schichtenfolge in zumindest dieser Ausführungsform zur Strahlungserzeugung oder Strahlungsdetektion vorgesehen.

Gemäß zumindest einer Ausführungsform des optoelektronischen Halbleiterchips ist die Aufwachsfläche des Aufwachssubstrats regelmäßig strukturiert. Das heißt, die Strukturen auf der Aufwachsfläche sind in vorgegebener Weise nach bestimmten Regeln erzeugt. Beispielsweise sind die Strukturen mittels eines lithographischen Prozesses mit anschließender isotroper Ätzung erzeugt. Auf diese Weise können beispielsweise über die gesamte Aufwachsfläche Erhebungen und/oder Senken erzeugt werden, deren Strukturgrößen im Wesentlichen gleich sind. Im Wesentlichen gleich bedeutet beispielsweise, dass die Strukturgrößen der einzelnen Strukturen höchstens 10 % um einen Mittelwert der jeweiligen Strukturgröße variieren. Strukturgrößen von Erhebungen sind dabei beispielsweise die laterale Erstreckung der Erhebung, die Höhe der Erhebung und/oder der Flankenwinkel der Erhebung. Strukturgrößen einer Senke sind beispielsweise die laterale Erstreckung der Senke, die Tiefe der Senke und/oder der Flankenwinkel der Senke.

Gemäß zumindest einer Ausführungsform des optoelektronischen Halbleiterchips ist die Aufwachsfläche derart regelmäßig strukturiert, dass die Erhebungen und/oder Senken periodisch angeordnet sind. Die Erhebungen und/oder Senken bilden dann beispielsweise eine Art Wellenmuster auf der Aufwachsfläche aus. Der Abstand zwischen zwei benachbarten Erhebungen entlang einer vorgegebenen Richtung auf der Aufwachsfläche ist dann ein im Wesentlichen konstanter Wert - die Periodenlänge. Im Wesentlichen konstant bedeutet dabei wiederum, dass die Periodenlänge um höchsten 10 % um ihren Mittelwert schwankt.

Der mittlere Abstand zwischen zwei Erhebungen auf der Aufwachsfläche beträgt dabei vorzugsweise höchstens 2 µm, besonders bevorzugt höchstens 1 µm.

Gemäß zumindest einer Ausführungsform des optoelektronischen Halbleiterchips ist die Aufwachsfläche unregelmäßig strukturiert. Das heißt, die Aufwachsfläche ist in zufälliger oder näherungsweise zufälliger Weise strukturiert.

Eine unregelmäßige Strukturierung der Aufwachsfläche kann beispielsweise mit anisotropem Ätzen einer glatten Aufwachsfläche des Aufwachssubstrats erzeugt sein. Auf diese Weise wird eine kristallographisch aufgeraute Struktur erzeugt. Erhebungen und/oder Senken sind dann als unregelmäßige Strukturen auf der Aufwachsfläche ausgebildet. Das bedeutet, die Erhebungen und/oder Senken weisen ungleichmäßige Strukturgrößen und/oder Abstände auf. Der mittlere Abstand zwischen zwei Erhebungen beträgt in diesem Fall vorzugsweise höchstens 500 nm. Erhebungen und/oder Senken mit ungleichmäßigen Strukturgrößen können dabei regelmäßig oder unregelmäßig angeordnet sein.

Gemäß zumindest einer Ausführungsform des optoelektronischen Halbleiterchips ist bei einer unregelmäßigen Strukturierung der Aufwachsfläche der Flächeninhalt der aktiven Schichtenfolge größer als der Flächeninhalt der lateralen Querschnittsfläche des Aufwachssubstrats. Dies kann zum Beispiel dadurch erreicht sein, dass auf die unregelmäßig strukturierte Aufwachsfläche eine aktive Schichtenfolge epitaktisch abgeschieden, die dem Profil der strukturierten Aufwachsfläche nachfolgt. Das heißt mit anderen Worten, dass sich die aktive Schichtenfolge an die strukturierte Aufwachsfläche anschmiegt und dadurch einen größeren Flacheninhalt als die Querschnittsfläche des Aufwachssubstrats aufweist. Neben dem Vorteil der effektiv vergrößerten Fläche der aktiven Schichtenfolge bewirkt die aufgeraute Struktur der Aufwachsfläche auch eine verbesserte Auskopplung von beispielsweise in der aktiven Schichtenfolge erzeugtem Licht, da aufgrund der rauen Struktur der aktiven Schichtenfolge die Wahrscheinlichkeit für eine Totalreflexion des Lichts an einer der Außenflächen des optoelektronischen Halbleiterchips reduziert ist. Insgesamt ist durch die Strukturierung der Aufwachsfläche des Aufwachssubstrats die Oberfläche des Aufwachssubstrats und damit der Flächeninhalt der Aufwachsfläche vergrößert. Durch die Vergrößerung der Aufwachsfläche ist auch der Flächeninhalt der aktiven Schichtenfolge vergrößert. Auf diese Weise steht gegenüber einem Aufwachssubstrat mit glatter, ebener Aufwachsfläche mehr strahlungserzeugende und/oder strahlungsdetektierende Fläche der aktiven Schichtenfolge zur Verfügung. Auf diese Weise ist ein besonders effizienter optoelektronischer Halbleiterchip erzeugt, der zudem besonders kostengünstig ist, da die Chipfläche gegenüber herkömmlichen optoelektronischen Halbleiterchips reduziert werden kann, ohne dass sich die Lichtausbeute verschlechtert.

Gemäß zumindest einer Ausführungsform des optoelektronischen Halbleiterchips weist die aktive Schichtenfolge eine im Wesentlichen konstante Dicke auf. Eine im Wesentlichen konstante Dicke bedeutet dabei, dass die Dicke der aktiven Schichtenfolge um höchstens 10 % um eine mittlere Dicke der Schichtenfolge schwankt. Die mittlere Dicke der aktiven Schichtenfolge beträgt dabei vorzugsweise höchstens 20 µm.

Gemäß zumindest einer Ausführungsform des optoelektronischen Halbleiterchips erstreckt sich die Strukturierung der Aufwachsfläche über die gesamte Aufwachsfläche. Das bedeutet, die gesamte, von der aktiven Schichtenfolge bedeckte Fläche des Aufwachssubstrats ist strukturiert und weist zum Beispiel Erhebungen und/oder Senken auf.

Gemäß zumindest einer Ausführungsform enthält das Aufwachssubstrat GaN oder besteht aus GaN. Insbesondere ist es dann möglich, dass das Aufwachssubstrat n-dotiertes GaN enthält oder aus n-dotiertem GaN besteht. Die aktive Schichtenfolge basiert dann vorzugsweise auf Nitrid-Verbindungshalbleitern. Das n-dotierte Galliumnitrid-Aufwachssubstrat kann in diesem Fall als n-dotierte Kontaktschicht der aktiven Schichtenfolge dienen.

Gemäß zumindest einer Ausführungsform enthält das Aufwachssubstrat InGaN oder besteht aus InGaN.

Gemäß zumindest einer Ausführungsform enthält das Aufwachssubstrat AlGaN oder besteht aus AlGaN.

Gemäß zumindest einer Ausführungsform enthält das Aufwachssubstrat InAlGaN oder besteht aus InAlGaN.

Gemäß zumindest einer Ausführungsform enthält das Aufwachssubstrat oder besteht das Aufwachssubstrat aus einer ternären oder einen quaternären III-N Verbindung wie zum Beispiel InGaN, AlGaN oder InAlGaN.

Gemäß zumindest einer Ausführungsform enthält das Aufwachssubstrat SiC oder besteht aus SiC.

Gemäß zumindest einer Ausführungsform enthält das Aufwachssubstrat Saphir oder besteht aus Saphir.

Gemäß zumindest einer Ausführungsform enthält das Aufwachssubstrat oder besteht das Aufwachssubstrat aus einem oxidischen Halbleiter wie zum Biespiel ZnO.

Gemäß zumindest einer Ausführungsform des optoelektronischen Halbleiterchips basiert die aktive Schichtenfolge auf Nitrid-Verbindungshalbleitern. "Auf Nitrid-Verbindungshalbleitern basierend" bedeutet im vorliegenden Zusammenhang, dass die aktive Schichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters - Al, Ga, In, N -, auch wenn diese teilweise durch geringe Mengen weiterer Stoffe ersetzt sein können.

Gemäß zumindest einer Ausführungsform des optoelektronischen Halbleiterchips basiert die aktive Schichtenfolge auf Phosphid-Verbindungshalbleitern. "Auf Phosphid-Verbindungshalbleitern basierend" bedeutet in diesem Zusammenhang, dass die aktive Schichtenfolge oder zumindest eine Schicht davon vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (A1, Ga, In, P), auch wenn diese teilweise durch geringe Mengen weiterer Stoffe ersetzt sein können.

Gemäß zumindest einer Ausführungsform des optoelektronischen Halbleiterchips basiert die aktive Schichtenfolge auf Arsenid-Verbindungshalbleitern. "Auf Arsenid-Verbindungshalbleitern basierend" bedeutet in diesem Zusammenhang, dass die aktive Schichtenfolge oder zumindest eine Schicht davon vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (A1, Ga, In, As), auch wenn diese teilweise durch geringe Mengen weiterer Stoffe ersetzt sein können.

Gemäß zumindest einer Ausführungsform des optoelektronischen Halbleiterchips sind die Erhebungen und/oder Senken der Aufwachsfläche des Aufwachssubstrats durch zumindest einen Ätzprozess strukturiert. Dabei kann ein isotroper Ätzprozess zum Einsatz kommen, bei dem nachfolgend nach einem lithographischen Verfahren regelmäßige Strukturen in das Aufwachssubstrat geätzt werden. Ferner ist es möglich, dass die Aufwachsfläche mittels eines anisotropen Ätzverfahrens aufgeraut wird. Dieses anisotrope Ätzverfahren eignet sich besonders gut zur Herstellung unregelmäßiger, zufälliger Strukturen auf der Aufwachsfläche des Aufwachssubstrats.

Gemäß zumindest einer Ausführungsform sind die Erhebungen und/oder Senken epitaktisch erzeugt. Das heißt, auf eine ebene oder gestufte Aufwachsfläche des Aufwachssubstrats wird epitaktisch ein Material abgeschieden. Beispielsweise durch selbst-organisiertes Wachstum oder mittels einer Maskentechnik werden Erhebungen auf der Aufwachsfläche gewachsen. Auf diese Weise lassen sich sowohl regelmäßige als auch unregelmäßige Strukturen auf der Aufwachsfläche erzeugen.

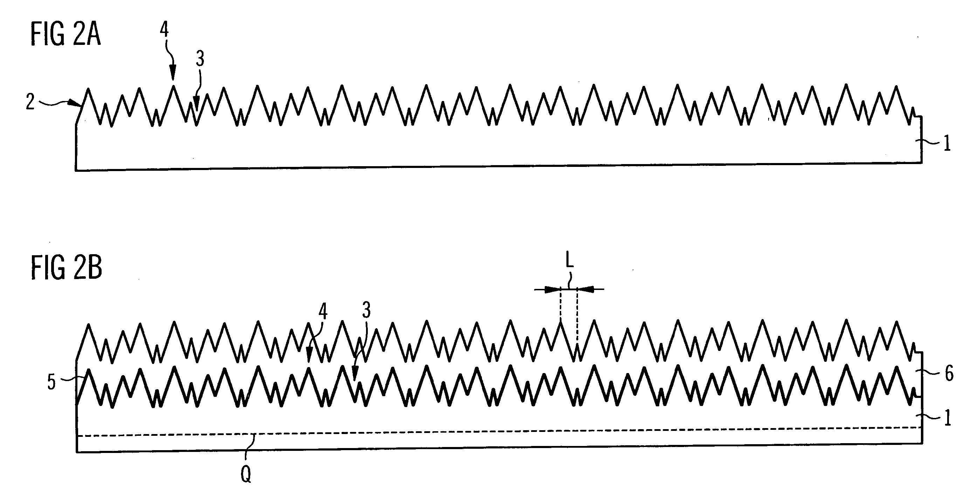

Im Folgenden wird der hier beschriebene optoelektronische Halbleiterchip anhand von Ausführungsbeispielen und den dazugehörigen Figuren näher erläutert.

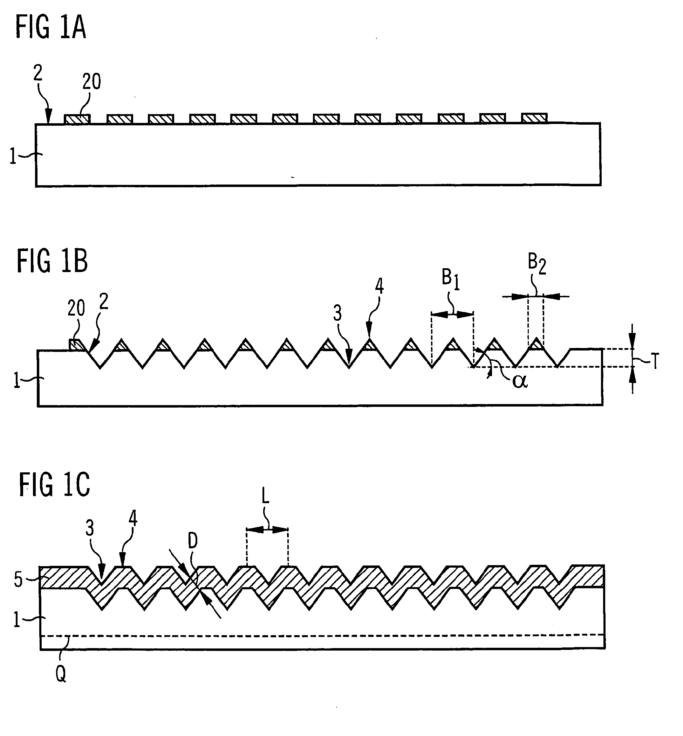

In den Figuren 1A, 1B und 1C ist anhand schematischer Schnittdarstellungen ein erstes Ausführungsbeispiel eines Verfahrens zur Herstellung eines hier beschriebenen optoelektronischen Halbleiterchips erläutert.
In Verbindung mit den Figuren 2A und 2B ist anhand schematischer Schnittdarstellungen ein zweites Ausführungsbeispiel eines Verfahrens zur Herstellung eines hier beschriebenen optoelektronischen Halbleiterchips beschrieben.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

In den Figuren 1A, 1B und 1C ist anhand schematischer Schnittdarstellungen ein erstes Ausführungsbeispiel eines Verfahrens zur Herstellung eines hier beschriebenen optoelektronischen Halbleiterchips beschrieben. Die Figur 1C zeigt in einer schematischen Schnittdarstellung einen hier beschriebenen optoelektronischen Halbleiterchip gemäß einem ersten Ausführungsbeispiel.

Die Figur 1A zeigt ein Aufwachssubstrat 1 mit einer ebenen, glatten Aufwachsfläche 2. Bei dem Aufwachssubstrat 1 handelt es sich beispielsweise um ein n-dotiertes GaN Aufwachssubstrat. Auf das Aufwachssubstrat ist eine strukturierte Fotolackschicht 20 aufgebracht. Die Fotolackschicht 20 ist beispielsweise mittels eines lithographischen Verfahrens strukturiert.

Das Aufwachssubstrat 1 wird in einem nächsten, in Verbindung mit der Figur 1B beschriebenen Verfahrensschritt isotrop geätzt. Das heißt, nicht von der strukturierten Fotolackschicht 20 bedeckte Bereiche der Aufwachsfläche 2 des Aufwachssubstrats 1 werden geätzt. Auf diese Weise entstehen auf der Aufwachsfläche 2 Senken 3 sowie Erhebungen 4.

Durch den isotropen Ätzprozess sind periodische Strukturen in die Aufwachsfläche 2 des Aufwachssubstrats 1 strukturiert.

Der mittlere Abstand L zwischen zwei Erhebungen 4 des Aufwachssubstrats 1 beträgt dabei höchsten 20 µm, vorzugsweise höchstens 2 µm, besonders bevorzugt höchstens 1 µm.

Die mittlere Breite B1 der Basis einer Erhebungen 4 des Aufwachssubstrats 1 beträgt dabei höchsten 20 µm, vorzugsweise höchstens 2 µm, besonders bevorzugt höchstens 1 µm. Bevorzugt entspricht die Breite B1 der Basis einer Erhebungen 4 gleich dem mittleren Abstand L zwischen zwei Erhebungen 4.

Die mittlere Tiefe T einer Erhebungen 4 des Aufwachssubstrats 1 beträgt dabei höchsten 20 µm, vorzugsweise höchstens 2 µm, besonders bevorzugt höchstens 1 µm.

Die mittlere Breite B2 an der Spitze einer Erhebungen 4 des Aufwachssubstrats 1 beträgt dabei höchsten 5 µm, vorzugsweise höchstens 1 µm, besonders bevorzugt höchstens 0,2 µm.

Der Flankenwinkel α einer Erhebung 4 ergibt sich entsprechend aus diesen Werten.

Nachfolgend wird die verbleibende Fotolackschicht 20 vom Aufwachssubstrat 1 abgelöst.

Die Figur 1C zeigt ein erstes Ausführungsbeispiel eines hier beschrieben optoelektronischen Halbleiterchips. Bei dem optoelektronischen Halbleiterchip handelt es sich zum Beispiel um einen Leuchtdiodenchip, einen Laserdiodenchip oder einen Photodetektorchip.

Dabei ist eine aktive Schichtenfolge 5 epitaktisch auf die strukturierte Aufwachsfläche 2 des Aufwachssubstrats 1 mit Senken 3 und Erhebungen 4 abgeschieden.

Die aktive Schichtenfolge 5 folgt in ihrem Verlauf dem Profil der Aufwachsfläche 2 nach. Das heißt, es befinden sich Senken der aktiven Schichtenfolge 5 bei Senken 3 des Aufwachssubstrats 1 sowie Erhebungen der aktiven Schichtenfolge 5 bei Erhebungen 4 des Aufwachssubstrats 1.

Vorzugsweise handelt es sich bei der aktiven Schichtenfolge 5 um eine Schicht gleichmäßiger Dicke. Die Dicke D der aktiven Schicht 5 beträgt vorzugsweise 6 µm, wenigsten 10nm und höchsten 20 µm.

Die gestrichelte Linie Q deutet die laterale Querschnittsfläche des Halbleiterchips an.

Die aktive Schichtenfolge 5 umfasst zumindest eine Schicht, die zur Strahlungserzeugung und/oder Strahlungsdetektion vorgesehen ist. Vorzugsweise umfasst die aktive Schichtenfolge einen pn-Übergang, eine Doppelheterostruktur oder eine Quantentopfstruktur.

Die Bezeichnung Quantentopfstruktur umfasst im Rahmen der Offenbarung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

In Verbindung mit den Figuren 2A und 2B ist anhand schematischer Schnittdarstellungen ein zweites Ausführungsbeispiel eines Verfahrens zur Herstellung eines hier beschriebenen optoelektronischen Halbleiterchips beschrieben. Wie in Figur 2A dargestellt, wird zunächst die Aufwachsfläche 2 des Substrats 1 aufgeraut.

Dies geschieht beispielsweise mittels anisotropen Ätzes. Beispielsweise handelt es sich bei dem Aufwachssubstrat 1 um ein GaN-Substrat, das mittels heißem Kaliumhydroxid - KOH - durch anisotropes Ätzen aufgeraut ist. Auf diese Weise ist eine kristallographisch aufgeraute strukturierte Aufwachsfläche 2 erzeugt. Der mittlere Abstand L zweier Erhebungen 4 beträgt dabei höchstens 5 µm, bevorzugt höchstens 2, besonders bevorzugt höchsten 0,5 µm.

Die Konzentration des Kaliumhydroxids beträgt dabei vorzugsweise zwischen 10% und 50%. Die Temperatur des Kaliumhydroxids beträgt bevorzugt zwischen wenigsten 25 Grad Celsius und 95 Grad Celsius. Die Ätzdauer beträgt bevorzugt zwischen wenigstens 1 Minute und höchstens einer Stunde. Die Rauhigkeit der derart erzeugten Strukturen ist bevorzugt größer 0,1 µm.

Wie in Figur 2B anhand einer schematischen Schnittdarstellung dargestellt, wird auf die strukturierte Aufwachsfläche 2 eine aktive Schichtenfolge 5 epitaktisch abgeschieden, die dem Profil der strukturierten Aufwachsfläche 2 nachfolgt. Auf die aktive Schichtenfolge 5 ist eine p-Kontaktschicht 6 aufgebracht, die beispielsweise p-dotiertes GaN enthält oder aus diesem besteht.

Neben dem Vorteil der effektiv vergrößerten Fläche der aktiven Schichtenfolge bewirkt die aufgeraute Struktur der Aufwachsfläche 2 auch eine verbesserte Auskopplung von beispielsweise in der aktiven Schichtenfolge 5 erzeugtem Licht, da aufgrund der rauen Struktur der aktiven Schichtenfolge 5 sowie der rauen Struktur der Oberfläche der p-Kontaktschicht 6 die Wahrscheinlichkeit für eine Totalreflexion des Lichts an einer der Außenflächen des optoelektronischen Halbleiterchips reduziert ist.

Insgesamt ist durch die Strukturierung der Aufwachsfläche 2 des Aufwachssubstrats 1 die Oberfläche des Aufwachssubstrats 1 und damit der Flächeninhalt der Aufwachsfläche 2 vergrößert. Durch die Vergrößerung der Aufwachsfläche 2 ist auch der Flächeninhalt der aktiven Schichtenfolge 5 vergrößert. Auf diese Weise steht gegenüber einem Aufwachssubstrat mit glatter, ebener Aufwachsfläche mehr strahlungserzeugende und/oder strahlungsdetektierende Fläche der aktiven Schichtenfolge 5 zur Verfügung. Auf diese Weise ist ein besonders effizienter optoelektronischer Halbleiterchip erzeugt, der zudem besonders kostengünstig ist, da die Chipfläche gegenüber herkömmlichen optoelektronischen Halbleiterchips reduziert werden kann.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 102006043400.5, deren Offenbarungsgehalt hiermit durch Rückbezug aufgenommen wird.

## Patentansprüche

1. Optoelektronischer Halbleiterchip aufweisend
- ein Aufwachssubstrat (1) mit einer strukturierten Aufwachsfläche (2), die eine Vielzahl von Erhebungen (4) und Senken (3) aufweist, und
- einer aktiven Schichtenfolge (5), die auf die Aufwachsfläche (2) aufgebracht ist.

2. Optoelektronischer Halbleiterchip nach dem vorherigen Anspruch, bei dem der Flächeninhalt der aktiven Schichtenfolge (2) größer ist als der Flächeninhalt der lateralen Querschnittsfläche (Q) des Aufwachssubstrats (1).

3. Optoelektronischer Halbleiterchip nach zumindest einem der vorherigen Ansprüche, bei dem im Betrieb des optoelektronischen Halbleiterchips über die gesamte Fläche der aktiven Schichtenfolge (5) elektromagnetische Strahlung erzeugt oder detektiert wird.

4. Optoelektronischer Halbleiterchip nach zumindest einem der vorherigen Ansprüche, bei dem die Aufwachsfläche (2) regelmäßig strukturiert ist.

5. Optoelektronischer Halbleiterchip nach zumindest einem der vorherigen Ansprüche, bei dem die Erhebungen (4) und Senken (3) periodisch angeordnet sind.

6. Optoelektronischer Halbleiterchip nach zumindest einem der vorherigen Ansprüche, bei dem die Aufwachsfläche (2) unregelmäßig strukturiert ist.

7. Optoelektronischer Halbleiterchip nach Anspruch 1, bei dem die Aufwachsfläche (2) unregelmäßig strukturiert ist und bei dem der Flächeninhalt der aktiven Schichtenfolge (2) größer ist als der Flächeninhalt der lateralen Querschnittsfläche (Q) des Aufwachssubstrats (1).

8. Optoelektronischer Halbleiterchip nach zumindest einem der vorherigen Ansprüche, bei dem die Erhebungen (4) und Senken (3) als unregelmäßige Strukturen ausgebildet sind.

9. Optoelektronischer Halbleiterchip nach zumindest einem der vorherigen Ansprüche, bei dem der mittlere Abstand (L) zwischen zwei Erhebungen (4) der strukturierten Aufwachsfläche höchstens 2 µm beträgt.

10. Optoelektronischer Halbleiterchip nach zumindest einem der vorherigen Ansprüche, bei dem der mittlere Abstand (L) zwischen zwei Erhebungen (4) der strukturierten Aufwachsfläche höchstens 1 µm beträgt.

11. Optoelektronischer Halbleiterchip nach zumindest einem der vorherigen Ansprüche, bei dem der mittlere Abstand (L) zwischen zwei Erhebungen (4) der strukturierten Aufwachsfläche höchstens 0,5 µm beträgt.

12. Optoelektronischer Halbleiterchip nach zumindest einem der vorherigen Ansprüche, bei dem die aktive Schichtenfolge (5) eine mittlere Dicke (D) von höchsten 20 µm aufweist.

13. Optoelektronischer Halbleiterchip nach zumindest einem der vorherigen Ansprüche, bei dem sich die Erhebungen (4) und Senken (3) über die gesamte strukturierte Aufwachsfläche (2) erstrecken.

14. Optoelektronischer Halbleiterchip nach zumindest einem der vorherigen Ansprüche, bei dem das Aufwachsubstrat (1) aus einem der folgenden Materialien besteht oder eines der folgenden Materialen enthält: GaN, SiC, Saphir, InGaN, AlGaN, InAlGaN, ZnO.

15. Optoelektronischer Halbleiterchip nach zumindest einem der vorherigen Ansprüche, bei dem das Aufwachsubstrat (1) aus n-dotiertem GaN besteht.

16. Optoelektronischer Halbleiterchip nach zumindest einem der vorherigen Ansprüche, bei dem die Erhebungen (4) und Senken (3) durch zumindest einen Ätzprozess in die Aufwachsfläche (2) strukturiert sind.

17. Optoelektronischer Halbleiterchip nach zumindest einem der vorherigen Ansprüche, bei dem die Erhebungen (4) und Senken (3) epitaktisch erzeugt sind.

18. Optoelektronischer Halbleiterchip nach zumindest einem der vorherigen Ansprüche, bei dem der Halbleiterchip mit der strukturierten Aufwachsfläche (2) im Betrieb mehr elektromagnetische Strahlung erzeugt oder detektiert, als ein entsprechender Halbleiterchip mit glatter Aufwachsfläche.

19. Optoelektronischer Halbleiterchip nach zumindest einem der vorherigen Ansprüche, bei dem der Halbleiterchip mit der strukturierten Aufwachsfläche (2) im Betrieb elektromagnetische Strahlung einer höheren Strahlungsdichte erzeugt oder detektiert, als ein entsprechender Halbleiterchips mit glatter Aufwachsfläche, der die gleiche laterale Querschnittsfläche wie der Halbleiterchip mit der strukturierten Aufwachsfläche (2) aufweist.
